# EUROPEAN PATENT APPLICATION

(11) **EP 4 391 040 A1**
(43) Date of publication of application: **26.06.2024**
(21) Application number: 22214440.4
(22) Date of filing: 19.12.2022
(51) Int. Cl.: H01L 21/8234, H01L 27/088, H01L 29/06, H01L 29/66, H01L 29/775, H01L 29/786, H01L 23/528, H01L 21/74, H01L 23/535

(54) **AN INTEGRATED CIRCUIT DEVICE AND A METHOD FOR FORMING THE SAME**

(71) Applicant: IMEC VZW, 3001 Leuven (BE)
(72) Inventor: GUPTA, Anshul, 3001 Leuven (BE); MERTENS, Hans, 3000 Leuven (BE)
(74) Representative: AWA Sweden AB

(57) **Abstract**

The disclosure relates to a method for forming an integrated circuit device, comprising:
forming a forksheet device (102) on a frontside of a substrate (101), the forksheet device comprising a first (102a) and a second transistor (102b) separated by a vertically oriented dielectric wall (114), wherein the forksheet device is formed over a base portion of the substrate and the dielectric wall extends into the base portion;
subsequent to forming the forksheet device, thinning the substrate from a backside of the substrate;
subsequent to the thinning, forming a first trench underneath the first transistor and a second trench underneath the second transistor by etching the base portion from the backside, the first and second trenches being separated by the dielectric wall; and
forming a first backside wiring line(130a) in the first trench and a second backside wiring line (130b) in the second trench

The disclosure further relates to a semiconductor device comprising a forksheet device and first and second backside wiring lines.

## Description

### Technical field

The present disclosure relates to an integrated circuit device and a method for forming an integrated circuit device.

### Background

In the strive to provide even more area-efficient circuit designs, non-planar transistor devices have been developed, such as the FinFET and the horizontal or lateral nanosheet FET (NSHFET). In a NSHFET a number of channel nanosheets may be stacked in the vertical dimension to provide an increased drive current with a reduced horizontal footprint. A more recent NSHFET design is the so-called forksheet device. The forksheet device comprises two transistors of complementary conductivity types comprising a respective set of vertically stacked channel nanosheets on opposite sides of a vertically oriented dielectric wall. The transistors are controlled by a respective gate stack separated by the dielectric wall. The dielectric wall may be formed before gate patterning and source/drain epitaxy, and may hence facilitate individual processing of N- and P-type source/drain regions and gate stacks for the two transistors. The forksheet device hence enables aggressive scaling of the N-to-P spacing.

Integrated circuits typically comprise power rails (for example for VSS and VDD supply voltage distribution) which typically run at the boundary of a standard circuit cell (SDC) of logic gates. Traditionally, power rails have been fabricated within a back-end-of-line (BEOL) interconnect structure located above the level of the active physical devices (such as transistors). Current advanced technology nodes may in contrast be provided with a "buried" power rail (BPR) which may be embedded within the shallow trench isolation (STI) and substrate, such that the power rail may be located at a level below the active physical devices. Burying power rails allows to increase a height, and therefore a cross-sectional area, of the power rails which in turn reduces their resistance without occupying valuable space in the frontside BEOL interconnect structure, which instead may be used for signal routing.

Similar to the traditional BEOL power rails, in current technology, BPR is typically positioned at the boundary of a SDC, beside the active devices. A source/drain contact (M0A) of an adjacent active device may be tapped to the BPR from above by a Via-to-BPR. By placing the BPR and the Via-to-BPR to the side besides the active devices, the widths of the BPR and the Via-to-BPR are hence be limited by an amount of available space adjacent the active devices (e.g. the M0A contact tip-to-tip). Conversely, a side-by-side placement of the BPR and the Via-to-BPR may hinder further scaling of the device spacing.

### Summary

In light of the above, it is an objective to provide an integrated circuit device combining the benefits of the forksheet device (e.g. improved area efficiency, reduced N-to-P spacing) with the benefits associated with BPRs (e.g. of reduced usage of routing resources in the frontside BEOL interconnect structure). It is further an objective to provide a method allowing fabrication of such an integrated circuit device.

Further and alternative objectives may be understood from the following.

According to a first aspect there is provided a method for forming an integrated circuit device, comprising:
forming a forksheet device on a frontside of a substrate, the forksheet device comprising a first and a second transistor separated by a vertically oriented dielectric wall, wherein the forksheet device is formed over a base portion of the substrate and the dielectric wall extends into the base portion;
subsequent to forming the forksheet device, thinning the substrate from a backside of the substrate;
subsequent to the thinning, forming a first trench underneath the first transistor and a second trench underneath the second transistor by etching the base portion from the backside, the first and second trenches being separated by the dielectric wall; and
forming a first backside wiring line in the first trench and a second backside wiring line in the second trench.

The method allows forming of a backside wiring line underneath a first and a second transistor of a forksheet device. The backside wiring line may hence provide similar benefits as a traditional BPR, but occupy less area by being formed underneath the transistors. The area savings may instead be used to accommodate an increased width of the dielectric wall (e.g. to increase an isolation distance between the first and second transistor and between the first and second buried wiring lines), and/or to increase width of the channel nanosheets of the forksheet device to support higher drive currents. Alternatively, the forksheet device pitch can be reduced to achieve area scaling or higher device density.

According to the present method, the dielectric wall of the forksheet device provides additional functions of defining a partition between the first and second trenches (with a spacing determined by a width of the dielectric wall), as well as physically and electrically separating the first and second backside wiring lines.

Forming the trenches for the backside wiring lines during backside processing of the substrate allows the active device formation during frontside processing to be decoupled, i.e. proceed independently to, the fabrication of backside wiring lines. The frontside processing may thus be completed prior to forming the backside wiring lines. In a traditional scheme where the BPR is formed during frontside processing, prior to active device formation, there is a risk for metal contamination due to the presence of the BPR during the active device formation. The backside processing of the present method mitigates this risk.

An additional advantage of forming the first and second backside wiring lines underneath the first and the second transistors, is that a connection between the first/second backside wiring line and the active (e.g. source/drain) of the first and/or second transistor may be achieved without a front-side Via-to-BPR. Specific embodiments enabling this connection will be further set out in the following.

While the above discussion specifically refers to BPRs, it is envisaged that the present inventive concept has a broader applicability. Thus the buried wiring lines need not be dedicated to power delivery (like BPRs), but may more generally be used for backside signal routing, including but not-limited to routing power and/or routing signals for memory or logic applications.

As used herein, the term "forksheet device" refers to a device comprising a first and a second set of vertically stacked channel layers (nanosheets) formed on opposite sides of a vertically oriented dielectric wall. Each channel layer of the first set of vertically stacked channel layers have an inner edge contacting a first side of the dielectric wall and each channel layer of the second set of vertically stacked channel layers have an inner edge contacting a second side of the dielectric wall, opposite the first side. The forksheet device comprises a first gate stack surrounding the first set of vertically stacked channel layers and contacting the first side of the dielectric wall, and a second gate stack surrounding the second set of vertically stacked channel layers and contacting the second side of the dielectric wall.

The first transistor may comprise an N-type gate stack and the second transistor may comprise a P-type gate stack, or vice versa.

Forming of the forksheet device may comprise:
forming a first set of vertically stacked channel layers and a second set of vertically stacked channel layers separated by a trench extending into the base portion;
filling the trench with dielectric material to form the dielectric wall; and
forming a first gate stack surrounding the first set of vertically stacked channel layers and contacting the first side of the dielectric wall, and a second gate stack surrounding the second set of vertically stacked of channel layers and contacting the second side of the dielectric wall.

Spatial terms such as "horizontal" and "vertical", as used herein, are to be understood in relation to the substrate, wherein "horizontal" denotes an orientation or direction parallel to a main plane of extension of the substrate and "vertical" denotes an orientation or direction normal to the main plane of extension of the substrate. Correspondingly, relative spatial terms such as, "upper", "lower", "top", "bottom", "above", "under", "underneath", "below", are to be understood in relation to the substrate, as seen along the vertical/normal direction.

The terms "frontside" and "backside" of a substrate refer respectively to the two mutually opposite (main) sides of the substrate, wherein the frontside is the side of the substrate on which the transistor (and any further active devices) are formed and the backside is the opposite side of the substrate. The terms "frontside" and "backside" may also be used with reference to the integrated circuit device, with a corresponding meaning.

The term "source/drain" as used herein is to be understood as a source or a drain. Hence, "source/drain region" may either be a source region or a drain region.

In some embodiments, the first and the second trenches may be etched self-aligned to the dielectric wall. This facilities forming the first and second trenches, and thus the first and second backside wiring lines with a tight separation, while ensuring electrical and physical separation therebetween.

The first and the second trenches may be etched from a common opening patterned in a mask layer. This is enabled by the etching of the first and second trenches being self-aligned to the dielectric wall.

In some embodiments, the base portion may be a fin-shaped semiconductor portion protruding from the substrate and wherein the method may comprise thinning the substrate from the backside to expose the base portion from the backside. The fin-shaped semiconductor portion forming the base portion may hence be exposed from the backside wherein the first and second trenches may be etched therein.

Forming the first and second trenches may comprise etching the base portion to remove the base portion along at least a part of a length dimension thereof. The first and second trenches may accordingly be formed with a desired length dimension along the base portion. The etching may for instance remove the base portion along the entire length dimension thereof, such that first and second trenches may be formed with a length dimension corresponding to the entire length dimension of the base portion.

In some embodiments the base portion may be surrounded by a shallow-trench isolation (STI) structure. The first and second trenches may thus be etched self-aligned to the STI structure located at either side of the base portion.

In some embodiments, the dielectric wall may be coextensive with a length dimension of the base portion. This enables separation between the first and second trenches and the first and second backside wiring lines along the entire length dimension of the base portion.

In some embodiments, the substrate may comprise a first layer of a first semiconductor material and a second layer of a second semiconductor material on the first layer, wherein the second semiconductor material is different from each one of the first semiconductor material and a semiconductor material of the base portion, wherein the base portion is formed on the second layer, and wherein thinning the substrate may comprise removing the first layer from the backside using the second layer as a stop layer, and subsequently opening the second layer to expose the base portion.

Providing the second layer and using it as a stop layer for the thinning of the substrate may improve control over the amount of thinning. The second layer may be opened in part (e.g. to selectively expose the base portion), or removed completely from the backside.

The dielectric wall may extend through the base portion to the second layer. The second layer may hence be used to control a depth of the extension of the dielectric wall into the base portion. Additionally, by extending the dielectric wall to the second layer, the dielectric wall may separate the first and second trenches through the full thickness dimension of the base portion.

In some embodiments, the first transistor and the second transistor may be separated from the base portion by a bottom isolation layer, and wherein the method may further comprise:
patterning a via opening in the bottom isolation layer, the via opening exposing a source/drain region of the first transistor; and
forming a conductive via in the via opening for connecting the first backside wiring line to the source/drain region.

A connection between the first source/drain region and the first backside wiring line may hence be provided from a backside, instead of a conventional frontside connection by means of a Via-to-BPR. The method accordingly provides a backside contacting approach, further contributing to the area savings enabled by the backside wiring lines being formed underneath the transistors.

In some embodiments, a plurality of forksheet devices may be formed along a length dimension of the base portion, each forksheet device comprising a first transistor and a second transistor separated by the dielectric wall,
wherein the first trench and the first backside wiring line may be formed underneath each first transistor and the second trench and the second backside wiring line is formed underneath each second transistor.

First and second backside wiring lines may hence be formed underneath a plurality of forksheet devices formed along a length dimension of the base portion (which e.g. may be a fin-shaped semiconductor portion).

A via opening for a conductive via, to provide a backside contact between the first or second backside wiring line and a source/drain region of a first or second transistor, may be formed at one or more positions along the base portion.

According to a second aspect there is provided an integrated circuit device, comprising:
a forksheet device comprising a first transistor and second transistor separated by a vertically oriented dielectric wall; and
a first backside wiring line arranged underneath the first transistor and a second backside wiring line arranged underneath the second transistor, wherein the first backside wiring line and the second backside wiring line are separated by the dielectric wall.

The details and advantages of the method aspect apply correspondingly to the device aspect. More specifically, the integrated circuit (IC) device of the second aspect combines a forksheet device with an area efficient arrangement of first and second backside wiring lines, underneath the transistors of the forksheet device and separated by the dielectric wall. The dielectric wall (i.e. the "forksheet wall") hence provides a function of physically and electrically separating the first and second backside wiring lines, in addition to the conventional function of the forksheet wall (e.g. providing physical and electrical separation at the PN boundary between the first and second transistors).

In some embodiments, the integrated circuit device may further comprise a bottom isolation layer separating the first backside wiring line from the first transistor and the second backside wiring line from the second transistor; and
a conductive via extending through the bottom isolation layer and connecting the first backside wiring line to a source/drain region of the first transistor.

A connection between the first source/drain region and the first backside wiring line may hence be provided from a backside, instead of a conventional frontside connection by means of a Via-to-BPR, thus further contributing to the area efficiency.

In some embodiments, the integrated circuit device may further comprise a backside interconnect structure arranged underneath and connected to the first and the second backside wiring lines.

In some embodiments, the first and second backside wiring lines may be first and second backside power rails and wherein the backside interconnect structure may form a backside power delivery network.

### Brief description of the drawings

The above, as well as additional objects, features and advantages, may be better understood through the following illustrative and non-limiting detailed description, with reference to the appended drawings. In the drawings like reference numerals will be used for like elements unless stated otherwise.
Fig. 1a-b shows respective cross sections of an IC device according to an embodiment.

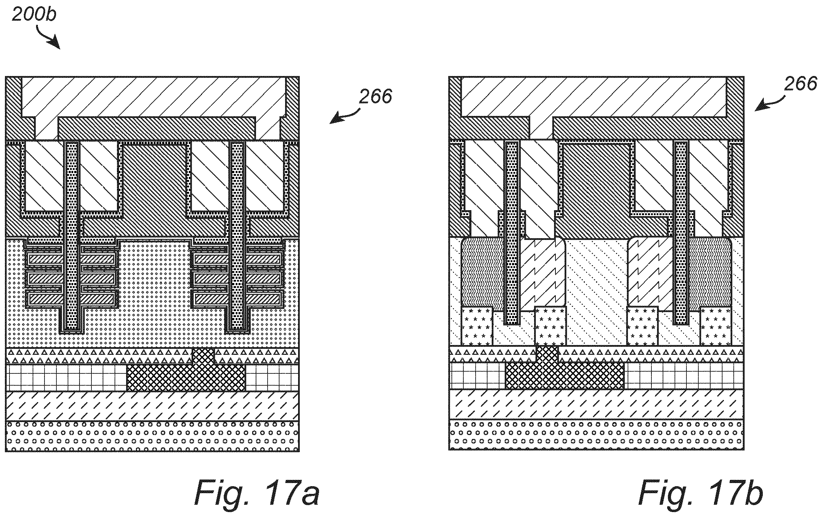

Fig. 2a-b to 17a-b illustrate a device structure at various stages of a method for forming an IC device according to an embodiment.

### Detailed description

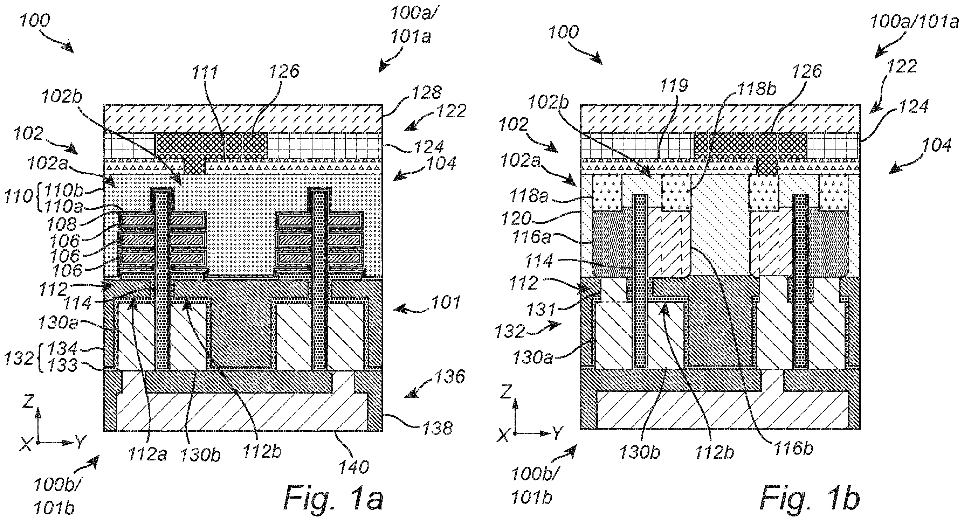

Fig. 1a-b shows respective cross sections of an IC device 100 (hereinafter "device 100") according to an embodiment. Fig. 1a shows a cross section taken along a gate and channel region of the device 100 and Fig. 1b shows a cross section taken along a source/drain region of the device 100. Axis X and Y indicate respectively a first and a second horizontal direction, parallel to the main plane of a substrate 101 of the device 100. Axis Z indicates a vertical direction, normal to the substrate 101. Reference signs 100a and 101a designate respectively a frontside of the device 100 and the substrate 101. Reference signs 100b and 101b designate respectively a backside of the device 100 and the substrate 101.

The device 100 comprises a forksheet device 102 comprising a first FET 102a and a second FET 102b, separated by a vertically oriented dielectric wall 114 (i.e. the "forksheet wall"). Suitable materials for the dielectric wall 114 include oxide, nitride or carbide materials, such as such as SiO₂, SiN, SiCO, SiCN or SiOCN. Single- as well as composite layer structures are possible. The dielectric wall 114 may for example be formed with a width (along the Y-direction) in a range from 8-20 nm. Reference will in the following primarily be made to the forksheet device 102, however the device 100 may generally comprise a plurality of corresponding forksheet devices, such as the forksheet device 104. The device 100 may comprise a plurality of forksheet devices 102, 104 along each gate. The device 100 may additionally comprise a plurality forksheet devices 102, 104 along each respective forksheet wall.

The first and second FETs 102a, 102b each comprise a respective set of vertically stacked channel layers in the form of nanosheets 106. An inner edge of each channel layer 106 of the first FET 102a contacts the dielectric wall 114 from a first side. An inner edge of each channel layer 106 of the second FET 102b contacts the dielectric wall 114 from a second side opposite the first side.

The channel layers 106 extend along the X-direction between a pair of source/drain (S/D) regions, wherein Fig. 1b shows a first S/D region 116a of the first FET 102a and a first S/D region 116b of the second FET 102b. Corresponding second S/D regions are present at the opposite ends of the channel layers 106. The first S/D regions 116a, 116b may be formed by a respective body of epitaxial semiconductor material, doped in accordance with the desired conductivity type of the respective FETs 102a, 102b.

The forksheet device 102 comprises a gate stack surrounding the channel layers 106 of the first and second FETs 102a, 102b. The gate stack may form an elongated structure and extend across the FETs 102a, 102b in the Y-direction. The gate stack may as shown comprise a gate dielectric 108 (e.g. HfO₂, HfSiO, LaO, AlO or ZrO, or another conventional a high-k dielectric) formed on the channel layers 106, and a number of gate metal layers 110, such as one or more work function metal (WFM) layers 110a (e.g. N-type WFMs such as TiAl or TiAlC, and/or P-type WFMs such as TiN or TiN) and a gate metal fill 110b (e.g. W, Al, Co or Ru). While Fig. 1a schematically shows a gate stack with a same composition at the first and second FETs 102a, 102b, the gate stack may typically comprise an N-type (or P-type) gate stack portion at the first FET 102a and a P-type (or N-type) gate stack portion at the second FET 102b, such that the forksheet device 102 forms a CMOS device.

The respective gate stack portions of the first and second FETs 102a, 102b have as shown a fork-like shape, with a number of prongs extending along and between the channel layers 106 of the respective FETs 102a, 102b. In the illustrated example the gate stack extends over the dielectric wall 114 such that the gate stack portions of the respective FETs 102a, 102b are electrically connected across the dielectric wall 114. However it is also possible to provide the first and second FETs 102a, 102b with disconnected gate stacks by recessing the gate stack to a level below the dielectric wall 114.

The gate stack is capped by a dielectric layer or "gate cap" 111. The gate cap 111 may e.g. be formed of a nitride or a carbide such as SiN, SiC, SiCO, SiCN or SiBCN, or combinations thereof. While not visible in the crosssections of Fig. 1a-b, the gate stack may further be provided with a gate spacer, extending along the opposite vertically oriented sidewalls of the gate stack. The gate spacer may be formed of a nitride or carbide, such as any of the material examples mentioned for the gate cap 111.

The first and second FETs 102a, 102b may further comprise inner spacers arranged over and underneath respective end portions of each channel layer 106, between the gate stack and the S/D regions (e.g. 106a, 1 06b). As per se is known in the art, inner spacers are typically provided for physical and electrical separation between the S/D regions and the gate stack. Inner spacers may additionally serve to facilitate various process steps during device fabrication, such as during "channel release" wherein the inner spacers may counteract etching of the S/D regions (e.g. during removal of sacrificial layers).

The device 100 comprises an interlayer dielectric (ILD) layer 120 covering the S/D regions 106a, 106b (as well as the opposite S/D regions). The ILD layer 120 may be formed of for instance SiO₂ or another insulating material suitable as an interlayer dielectric.

S/D contacts such as S/D contacts 118a, 118b are formed in the ILD layer 120, in contact with a respective one of the S/D regions 116a, 116b. The S/D contacts 118a, 118b may form part of the contact level (M0A) of the device 100. In Fig. 1b, a S/D contact 118a, 118b is provided on each of the first S/D regions 116a, 116b. This is however merely an illustrative example and what particular S/D regions are to be contacted may vary. The S/D contacts 118a, 118b and the ILD layer 120 may be capped by a dielectric layer or "contact cap" 119. The contact cap 119 may be formed of an oxide or nitride material different from a material of the ILD layer 120 and the gate cap 111, although in the figures a same fill pattern has for simplicity been used for the gap 111 and the contact cap 119.

The device 100 further comprises a frontside interconnect structure 122 arranged over the contact level. Fig. 1a-b shows a first interconnection level (M1) comprising a network of metal wiring lines schematically represented by 126. The metal wiring lines 126 are surrounded by a layer 124 of ILD. The metal lines may be connected to gates and contacts below by vertically oriented metal vias, e.g. extending through the gate cap 111 or the contact cap 119 as the case may be. The frontside interconnect structure 122 may as schematically shown comprise a stack of further interconnection levels 128 (e.g. M2, M3 etc.).

The device 100 comprises a first backside wiring line (BSWL) 130a arranged underneath the first FET 102a and a second BSWL 130b arranged underneath the second FET 102b and separated from the first BSWL 130a by the dielectric wall 114. Suitable materials for the first and second BSWLs 130a, 130b include for instance W, Ru, Mo, or combinations thereof. The first and second BSWLs 130a, 130b may additionally comprise a metal barrier or liner, such as TiN. As discussed earlier, the specific type of signals to be routed by first and second BSWLs 130a, 130b may depend on the particular application but may according to one example be power signals wherein the first and second BSWLs 130a, 130b may form first and second backside power rails (BSPRs).

The first and second BSWLs 130a, 130b extend in parallel along the X-direction and are spaced apart along the Y-direction. The first and second BSWLs 130a, 130b may extend along at least a part of a longitudinal dimension (along the X-direction) of the dielectric wall 114. The first and second BSWLs 130a, 130b may extend underneath one or more of a plurality of forksheet devices formed along the dielectric wall 114. The first and second BSWLs 130a, 130b may in particular be coextensive with the longitudinal dimension of the dielectric wall 114, wherein the first and second BSWLs 130a, 130b may extend underneath each forksheet device formed along the dielectric wall 114.

The first and second BSWLs 130a, 130b are surrounded by an STI structure 132, formed on either side of the dielectric wall 114. The STI structure 132 comprises as shown a dielectric liner 133, e.g. of a nitride such as SiN, and an STI oxide 134, such as SiO₂. The dielectric liner 133 may according to another example be omitted wherein the STI structure 132 may comprise only the STI oxide 134.

The first and second BSWLs 130a, 130b are physically separated from the first and second FETs 102a, 102b by a bottom isolation layer 112 comprising a first bottom isolation layer portion 112a between the first BSWL 130a and the first FET 102a and a second bottom isolation layer portion 112b between the second BSWL 130b and the second FET 102b. The dielectric wall 114 extends through the bottom isolation layer 112 such that the first and second bottom isolation layer portions 112a, 112b are arranged on opposite sides of the dielectric wall 114. The bottom isolation layer 112 may as per the illustrated example comprise portions of the STI 134 and the dielectric liner 133 arranged in a space underneath the first and second FETs 102a, 102b. However, the specific composition of the bottom isolation layer 112a, 112b may vary depending on the fabrication process used to form the forksheet device 102 and may also be formed of a separately formed dielectric layer of another dielectric material than the STI 134 and the dielectric liner 133.

The first BSWL 130a is connected to the first S/D region 116a by a conductive via 131 extending in the Z-direction through the first bottom isolation layer portion 112a, to contact an underside of the first S/D region 116a of the first FET 102a. The conductive via 131 may be formed of a metal, such as any of the examples metals mentioned for the first and second BSWLs 130a, 130b. The conductive via 131 may in particular form an integral portion of the first BSWL 130a. In other words, the first BSWL 130a may comprise a via contact portion 131 extending through the first bottom isolation layer portion 112a to contact the first S/D region 116a. In the illustrated example the first S/D region 116a but not the second S/D region 116b are connected to a BSWL, it is however possible to also connect the second BSWL 130b to the first S/D region 116b of the second FET 102b by a corresponding conductive via (e.g. as shown in Fig. 1b underneath the second forksheet device 104).

The device 100 further comprises a backside interconnect structure 136 arranged on a backside 100b/101b of the device/substrate 100/101, i.e. underneath the first and second BSWLs 130a, 130b. The backside interconnect structure 136 comprises a network of metal wiring lines 140 surrounded by a dielectric layer 138. The metal lines 140 are connected to the first and second BSWLs 130a, 130b at select locations by vertically oriented metal vias. While Fig. 1a-b only show a single level backside interconnect structure 136, it is to be noted that the interconnect structure 136 may comprise a stack of such interconnect levels, to provide further backside signal routing resources. In embodiments comprising BSPRs, the backside interconnect structure 136 may in particular define a backside power delivery network (PDN).

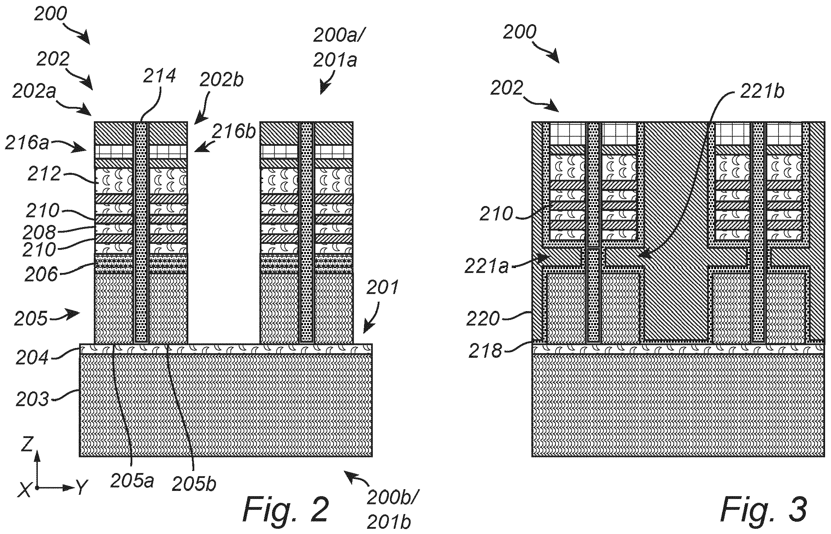

An embodiment of a method for forming an IC device, such as the IC device 100, will now be disclosed with reference to Fig. 2 and onwards. Like in Fig. 1a-b, axis X and Y respectively indicate first and second horizontal directions, and axis Z indicates a vertical direction.

Fig. 2 shows in cross section a device structure 200 comprising a substrate 201. Reference signs 200a and 201a designate respectively a frontside of the device structure 200 and the substrate 201, and reference signs 200b and 201b designate respectively a backside of the device structure 200 and the substrate 201, in correspondence with Figs. 1a-b.

A pair of fin structures 202 comprising a first fin structure 202a and a second fin structure 202b, has been formed on the substrate 201. The first and second fin structures 202a, 202b are separated by a trench filled with dielectric to form a dielectric wall 214 defining the forksheet wall. Reference will in the following mainly be made to a single pair of fin structures 202, however one or more additional fin structures, may as shown be simultaneously formed on the substrate 201, parallel to the parallel to the pair of fin structures 202.

The first and second fin structures 202a, 202b have a same layer structure and each comprises a number of vertically stacked channel layers 210 of a channel material and a number of vertically stacked sacrificial layers 208 of a first sacrificial material, arranged alternatingly with the channel layers 210. The channel material may be a first semiconductor material and the sacrificial material may be a second semiconductor material different from the first semiconductor material and selected to enable a selective removal and etching of the sacrificial layers 208 employing a selective etching process. This may be put to use for instance in a later described channel nanosheet release or channel nanowire release process (or merely channel release). As used herein, the wording "removing" or "etching" a first feature or material "selectively to" a second feature or material means that the first feature or material is removed or etched at a rate greater than the second feature or material, when exposed to the removal or etching process. Suitable compositions of channel material and sacrificial material include but are not limited to Si as channel material and SiGe (e.g. SiGe_{0.25}) as sacrificial material, or more generally Si₁₋ₓGeₓ as channel material and Si_{1-y}Ge_{y} as sacrificial material, wherein 0 ≤ x < y and y ≥ x + 0.15. For example, a SiGe material with a greater concentration of Ge than another Si or SiGe layer may be etched selectively (i.e. at a greater rate) using an HCl-based dry etch. A further example is ammonia peroxide mixture (APM). However, other appropriate etching processes (wet or dry) allowing selective etching of higher Ge-content SiGe layers with respect to lower Ge-content SiGe (or Si) layers are per se known in the art and may also be employed for this purpose.

The sacrificial layers 208 may be of a uniform thickness and the channel layers 210 may be of a uniform thickness. The sacrificial layers 208 may for example have a thickness of 5-15 nm, such as 7 nm. The channel layers 210 may for example have a thickness of 5-15 nm, such as 10 nm. The sacrificial layers 208 and the channel layers 210 may be formed in the shape of nanosheets, e.g. with a width in a range from 3-30 nm.

The fin structures 202a, 202b of the pair 202 further comprises a bottom sacrificial layer 206 underneath the sacrificial layers 208 and the channel layers 210. The bottom sacrificial layer 206 is formed of a second sacrificial material different from the first sacrificial material (e.g. a SiGe with a higher Ge-content than the first sacrificial material, such as SiGe_{0.5} or SiGe_{0.65}). As will be further described below, the bottom sacrificial layer 206 may facilitate forming of a bottom isolation layer underneath the sacrificial layers 208 and the channel layers 210. The bottom sacrificial layer 206 may be formed with a thickness to accommodate a bottom isolation layer of a desired thickness as described in greater detail below. As per the illustrated example, the bottom sacrificial layer 206 may for instance be thicker than the sacrificial layers 208.

The fin structures 202a, 202b as shown further comprises a top sacrificial layer 212 with a greater thickness than each one of the sacrificial layers 108. The top sacrificial layer 212 may be formed of a same material as the sacrificial layers 208. A thicker top sacrificial layer allows forming the dielectric wall 214 with an increased height above the channel layers 212, but may otherwise be considered optional. For conciseness, the term "sacrificial layer" and reference sign 208 will in the following be considered to encompass also a (potentially thicker) top sacrificial layer, unless stated otherwise.

The semiconductor layers of the pair of fin structures 202 (e.g. 206, 208, 210) may each be formed using deposition techniques which per se are known, such as chemical vapor deposition (CVD) or physical vapor deposition (PVD). Some or all of the semiconductor layers (e.g. at least the channel layers 210) may be formed as epitaxial layers, i.e. be epitaxially grown.

The substrate 201 comprises a first layer 203, a second layer 204 on the first layer 203 and a third layer 205 on the second layer 204. The first layer 203 may for instance be a bulk layer of Si, or an epitaxial layer of Si, e.g. of a silicon-on-insulator (SOI) substrate. The second layer 204 may be an epitaxial layer of SiGe. The third layer 205 may be an expitaxial layer of Si, or alternatively a SiGe layer with a different (e.g. lower) Ge-content than the second layer 204 and the bottom sacrificial layer 206 (if present). As further discussed below, the third layer 205 has been patterned when forming the pair of fin structures 202 to form a base portion (for simplicity also referred to by reference sign 205) in the shape of a fin-shaped semiconductor of the substrate 201, underneath the pair of fin structures 202. The base portion protrudes vertically (along the Z-direction) from the second layer 204. The dielectric wall 214 is formed to extend through the patterned third layer 206 / the base portion 205, thereby separating the base portion into a first part 205a underneath the first fin structure 202a and a second part 205b underneath the second fin structure 202b. A corresponding fin-shaped base portion may as shown be formed underneath each further pair of fin structures.

The pair of fin structures 202 may be formed by patterning first trenches in a layer stack formed on the substrate 201 to form initial fin structures surrounded by first trenches on either side. A second trench for the dielectric wall 214 may thereafter be patterned in each initial fin structure, thereby partitioning each initial fin structure into a pair of fin structures, e.g. the pair of fin structures 202 comprising the first fin structure 202a and the second fin structure 202b. The first and the second trenches may be etched into the substrate 201, stopping on the second layer 204 (wherein the different material of the second layer 204 and the third layer 205 enables using the second layer 204 as an etch stop layer). Hard mask portions 216a, 216b used during the patterning may be preserved on top of the fin structures 202 for protection until a subsequent fin reveal, discussed below. In either case, each second trench may thereafter be filled with insulating material to form the dielectric walls such as the wall 214. The insulating material may be conformally deposited, e.g. using atomic layer deposition (ALD), to fill the trench and subsequently be etched back to remove portions of insulating material deposited outside the trenches. As may be appreciated, the second trenches may be narrower than the first trenches such that the insulating material may be deposited to pinch off and completely fill the second trenches without causing pinch off and fill of the first trenches. The second trenches may for example be formed with a respective width in a range from 8-20 nm. A width of the first trenches may be at least two times a width of the second trenches. Suitable insulating materials for the dielectric wall 214 include one or more of a nitride or carbide material, such as such as SiN, SiCO, SiCN or SiOCN deposited e.g. by ALD. Optionally, an oxide liner (e.g., an ALD-oxide or thermal oxide, such as SiO₂) may be deposited prior to the nitride or carbide material for protection and/or improved adhesion to the fin structures 202a, 202b.

The first and second trenches may be formed using single- as well as multiple-patterning techniques, e.g. self-aligned double patterning (SADP), or quadruple patterning (SAQP) or some other conventional self-aligned multiple patterning (SAMP) technique. The second trenches may for instance be formed using a lithography and etching process after forming the first trenches. The second trenches may also be are formed prior to the first trenches, wherein the dielectric walls may be formed in the second trenches prior to forming the first trenches. The order and manner of forming the first and second trenches and the dielectric walls may however vary with the specific choice of patterning techniques. For instance, the different widths of the first and second trenches may be provided by introducing an intentional pitch walk in a SADP, SAQP or SAMP process.

In Fig. 3 an STI oxide 220 has been deposited to fill the first trenches and surround the pair of fin structures 202. Suitable materials for the STI oxide 220 include conventional interlayer dielectric oxides, for instance an CVD or flowable-CVD deposited SiO₂. Prior to forming the STI oxide 220, a dielectric liner 218 (e.g. an ALD-nitride such as SiN or a thermal oxide) may as shown be formed on the pair of fin structures 202 and the substrate 201. Following deposition, the STI oxide 220 may be subjected to a planarization process comprising e.g. chemical mechanical polishing (CMP). The planarization process may further remove, partly as shown or fully, hard mask portions 216a, 216b remaining from the preceding trench patterning.

Prior to depositing the STI oxide 220, the bottom sacrificial layer 206 has been removed by etching the second sacrificial material selectively to the materials of the sacrificial layers 208 and channel layers 210 of the pair of fin structures 202, thereby forming a pair of cavities 221 on opposite sides of the dielectric wall 214 underneath the fin structures 202a, 202b being supported and suspended by the dielectric wall 214. The STI oxide 220 and the liner 218 (if present) may thus fill the cavities 221.

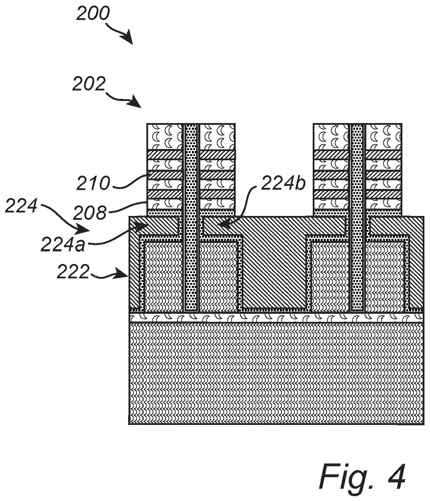

In Fig. 4, the STI oxide 220 and the dielectric liner 218 (if present) have been etched back to form an STI structure 222 and reveal the sacrificial layers 208 and channel layers 210. The STI structure 222 accordingly comprises the etched back STI oxide 220 and dielectric liner 218. If not fully removed already, the hard mask portions 216a, 216b may be removed in connection with the etch back of the STI oxide 220. The etch back of the STI oxide 220 and the dielectric liner 218 is stopped at a level above the cavities 221a-b such that the portions of the STI oxide 220 and/or dielectric liner 218 therein remain to form a bottom isolation layer 224 comprising portions 224a-b. A bottom isolation layer 224 may however also be formed using other techniques. For instance, a bottom isolation layer may be formed by conformally depositing a dielectric material (e.g. the SiN liner) with a thickness such that the cavities are pinched-off and filled with the dielectric material. The method may thereafter proceed with depositing the STI oxide 220.

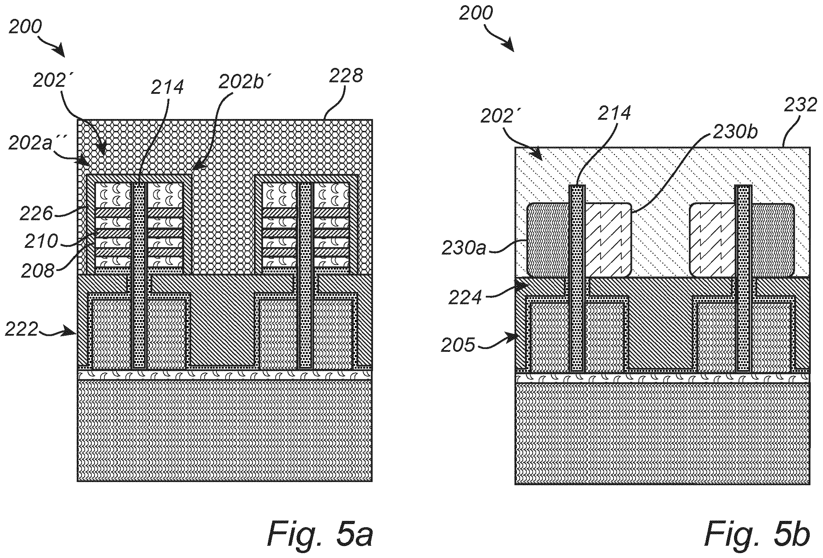

Fig. 5a-b shows the device structure 200 at a stage after conducting sacrificial gate patterning and S/D epitaxy. Fig. 5a shows a cross section taken along and through a sacrificial gate structure 228 and Fig. 5b shows a cross section taken along and through first S/D regions 230a, 230b formed on a pair of fin structure portions 202', on opposite sides of the dielectric wall 214. The sacrificial gate structure 228 extends along the Y-direction, across the pair of fin structure portions 202' and the dielectric wall 214. Similar to Fig. 1a-b, only the S/D regions 230a, 230b on one side of the sacrificial gate structure 228 are visible. However a corresponding set of S/D regions are formed on the opposite not shown side of the sacrificial gate structure 228. These S/D regions may in the following be referred to as the second S/D regions.

The sacrificial gate structure 228 may be formed using conventional techniques as per se known in the art. A sacrificial gate layer (e.g. amorphous Si) may be deposited over the device structure 200 (e.g. using CVD or PVD) and be patterned to form the sacrificial gate structure 228 (e.g. a plurality of parallel sacrificial gate structures) using single- or multiple-patterning techniques. A hard mask used during the sacrificial gate layer patterning may be preserved on top of the sacrificial gate structure 228 to form a gate cap (not shown). Depositing the sacrificial gate layer may as shown be preceded with forming a sacrificial gate dielectric 226 (e.g. a thermal oxide or an ALDdeposited oxide). A gate spacer (not shown) may further be formed by depositing a gate spacer material (e.g. using ALD). The gate spacer material may then be etched anisotropically (e.g. top-down) to remove the gate spacer material from horizontally oriented surfaces of the device structure 200 such that the gate spacer material remains on the vertically oriented sidewalls of the sacrificial gate structure 228.

After the gate structure formation, and prior to S/D epitaxy, fin recess may be performed. Fin recess may comprise recessing the pair of fin structures 202 at either side of the sacrificial gate structure 228 while using the sacrificial gate structure 228 and the gate spacer as an etch mask. The pair of fin structures 202 may hence be patterned to define a pair of fin structure portions 202' underneath the sacrificial gate structure 228 and the gate spacer. The pair of fin structure portions 202' comprises a first fin structure portion 202a' and a second fin structure portion 202b'. It is to be noted that the recessing of the fin structures 202 does not cause any appreciable recessing of the dielectric wall 214, such that the dielectric wall 214 remains on either side of the sacrificial gate structure 218. First and second S/D regions (of which only the first S/D regions 230a, 230b are visible in Fig. 5b) may then be formed by epitaxially growing semiconductor material at opposite sides of the sacrificial gate structure, in contact with end surfaces of the channel layer portions 210 of the pair of fin structure portions 202' (wherein the channel layer portions 210' are formed by the portions of the channel layers 210 preserved underneath the sacrificial gate structure 228 and the gate spacer after the fin recess). The S/D regions (including first S/D regions 230a, 230b) may for example be formed by selective area Si epitaxy on Si channel layer portions 210. Techniques such as in-situ doping and/or ion implantation may be used to define N-type and P-type S/D regions on opposite sides of the dielectric wall 214. For example, the first S/D region 230a and the corresponding second S/D region on the first fin structure portion 202a' may be formed as an N-type S/D region and first second S/D region 230b and the corresponding second S/D region on the second fin structure portion 202b' may be formed as a P-type S/D region, or vice versa. The S/D regions may be formed sequentially on the first and second fin structure portions 202a', 202b', while masking the other one of the first and second fin structure portions 202a', 202b', wherein the dielectric wall 214 may facilitate separation of the N- and P-sides.

Prior to S/D epitaxy, so-called "inner spacers" (i.e. of a dielectric) may be formed. Techniques for forming inner spacers are known in the art and may comprise forming recesses in the first and second fin structure portions 202a', 202b', on opposite sides of the sacrificial gate structure 218 using a lateral etch back (e.g. along the X- and negative X-directions) of end surfaces of sacrificial layer portions 208 of the pair of fin structure portions 202' (wherein the sacrificial layer portions 208 are formed by the portions of the sacrificial layers 208 and 212 preserved underneath the sacrificial gate structure 228 and the gate spacer after the fin recess). The lateral etch back of the sacrificial layer portions 208 may be achieved employing an isotropic etching process (wet or dry) selective to the sacrificial material (e.g. SiGe). Inner spacer material may then be deposited with a thickness such that the recesses are pinched-off (i.e. closed) by the spacer material. The inner spacer material may for example be deposited using conformal deposition techniques such as ALD. Portions of inner spacer material deposited outside the recesses may subsequently be removed using a suitable etching process (anisotropic or isotropic, wet or dry) to expose end surfaces of the channel layer portions 210 prior to the S/D epitaxy.

Finally, in Fig. 5b the sacrificial gate structure 228 has been surrounded by an ILD layer 232 covering the S/D regions (including the first S/D regions 230a, 230b). The ILD layer 232 may be formed by depositing one or more ILD materials (for instance SiO₂) and subsequently subjecting the ILD material(s) to a planarizing process, such as CMP, to expose an upper surface of the sacrificial gate structure 228. The forming of the ILD layer 232 may as per se is known in the art be preceded by depositing a contact etch stop layer (not shown) on the S/D regions.

Although in the above, reference is made to the single sacrificial gate structure 218 and the first and second fin structure portions 202a', 202b', it is to be noted that typically a plurality of additional sacrificial gate structures, parallel to the sacrificial gate structure 218, may be formed across the pair of fin structures 202. During fin recess, the pairs of fin structures 202 may be patterned to define a plurality of pairs of fin structure portions corresponding to the pairs of fin structure portions 202' and comprising respective first and second fin structure portions corresponding to the first and second fin structure portions 202a', 202b'. During the S/D epitaxy, S/D regions may be formed on each first and second fin structure portion, at either side of each sacrificial gate structure. This allows forming of a plurality of forksheet devices along a length dimension of the base portion 205, each forksheet device comprising a first FET and a second FET separated by the dielectric wall 214.

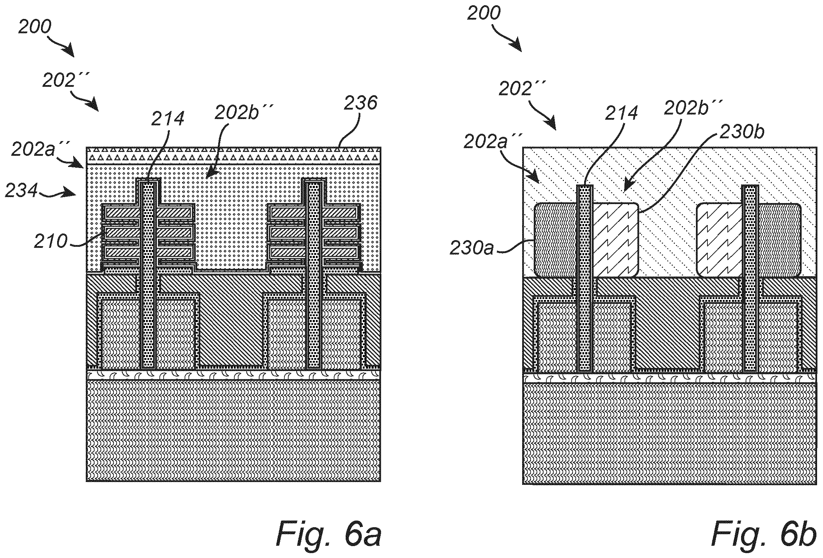

Fig. 6a-b shows the device structure 200 after conducting a replacement metal gate (RMG) process, comprising removing the sacrificial gate structure 228 and forming a functional gate stack 234 in its place (applicable to any further sacrificial gate structure), thereby forming a forksheet device 202" comprising a first FET 202a" and a second FET 202b" on opposite sides of the dielectric wall 214 (or a plurality of forksheet devices each comprising a first FET and a second FET on opposite sides of the dielectric wall 214). The gate stack 234 may have a same composition as the gate stack of the forksheet device 102 discussed above in connection with Fig. 1a-b. In particular, the gate stack 234 may comprise gate stack portions of opposite conductivity type at the first and second FET 202a", 202b". If a sacrificial gate dielectric 226 has been formed earlier in the flow, the RMG process may further comprise removing the sacrificial gate dielectric 226 and depositing a high-k gate dielectric.

As part of the replacement metal gate process, following removal of the sacrificial gate structure 228, the first and second fin structure portions 202a', 202b' may be subjected to a channel release process, comprising removing the sacrificial layer portions 208 selectively to the channel layer portions 210 to define released channel layer portions 210. The gate stack 234 may subsequently be deposited to surround the channel layer portions 210. Due to the presence of the dielectric wall 214, the channel layer portions 210 may not be "fully" released, but contact the dielectric wall 214 at respective inner edges of the channel layer portions 210.

The functional gate stack 234 may as shown be recessed (e.g. employing a metal etch back) and provided with a gate cap 236 corresponding to the gate cap 111 of the device 100. The gate cap 236 may be formed by depositing a dielectric material to fill the recess formed by recessing the functional gate stack 234 and removing overburden material using a planarization process comprising e.g. CMP.

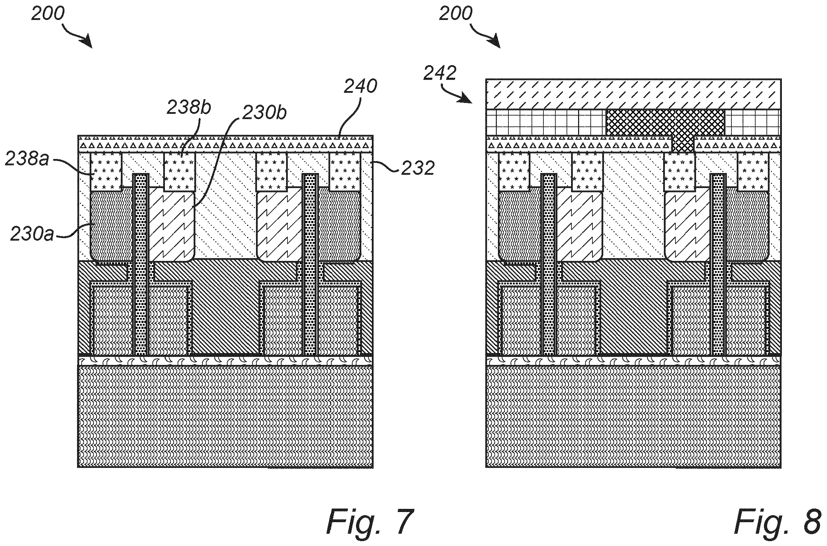

Fig. 7 shows the device structure 200 in the same cross section as Fig. 6b after forming S/D contacts 238a, 238b in the ILD layer 232, in contact with a respective one of the S/D regions 230a, 230b. The discussion of the S/D contacts 118a, 118b of the device 100 applies correspondingly to the S/D contacts 238a, 238b. The S/D contacts 238a, 238b may be formed by opening contact trenches in the ILD layer 232 (e.g. using a lithography and etching process) and subsequently (and after opening the contact etch stop layer if present) depositing one or more contact metals in the contact trenches. Overburden contact metal may be removed using a planarization process comprising e.g. CMP and/or metal etch back. After forming the S/D contacts 238a, 238b, a contact capping layer 240 (corresponding to the contact cap 119 of the device 100) may be formed over the S/D contacts 238a, 238b and the ILD layer 232.

In Fig. 8 a frontside interconnect structure 242 has been formed on top of the device structure 200. The frontside interconnect structure 242 corresponds to the frontside interconnect structure 122 of the device 100 and may be formed employing conventional BEOL techniques, such as damascene processing.

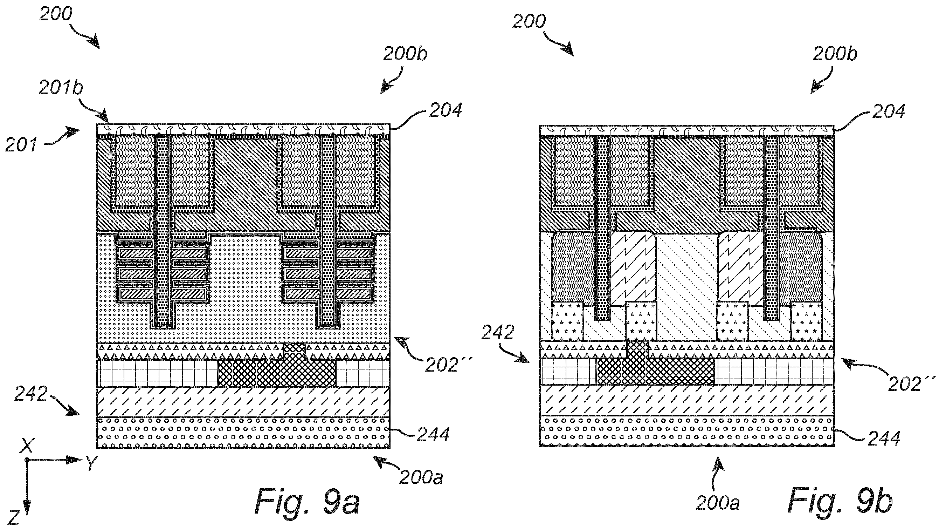

The forming of the frontside interconnect structure 242 concludes the frontside processing of the method. Fig. 9a-b shows the device structure 200 in two cross sections corresponding to Fig. 6a-b, respectively, after the device structure 200 have been flipped and bonded to a carrier wafer 244, with the frontside 200a (e.g. the frontside interconnect structure 242) facing the carrier wafer 244. Any suitable industry standard bonding technique may be used for this purpose. The substrate 201 has subsequently been thinned from the backside 201b to expose the second layer 204. The thinning may more specifically comprise thinning the third layer 203 from the backside 201b, and stopping on the second layer 204. The thinning process may comprise one or more of grinding, CMP, and/or etch back.

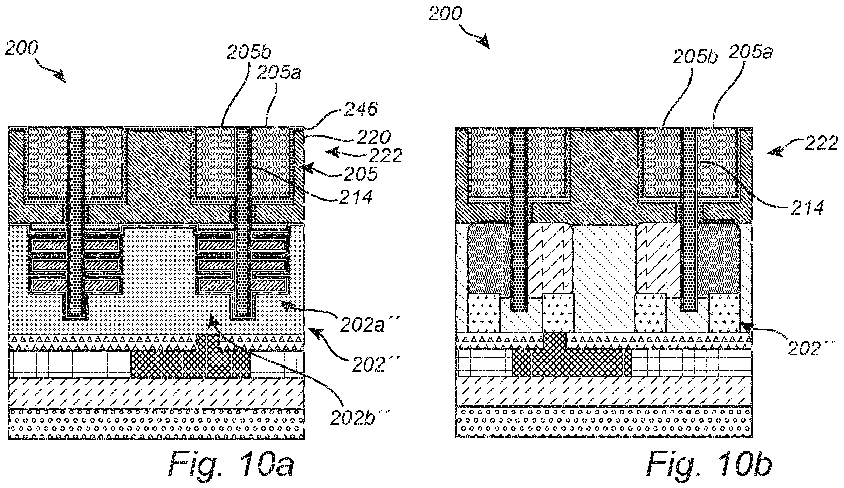

In Fig. 10a-b, the second layer 204 has been removed to expose an underside of the base portion 205 comprising the first part 205a underneath the first FET 202a" and the second part 205b underneath the second FET 202". The second layer 204 may be removed by a further CMP and/or etch back, either timed or using the base portion 205 and/or the STI structure 222 as a stop layer. In embodiments not comprising the second layer 204, the thinning of the substrate 201 may proceed directly until the underside of the base portion 205 and the STI structure 222 are exposed.

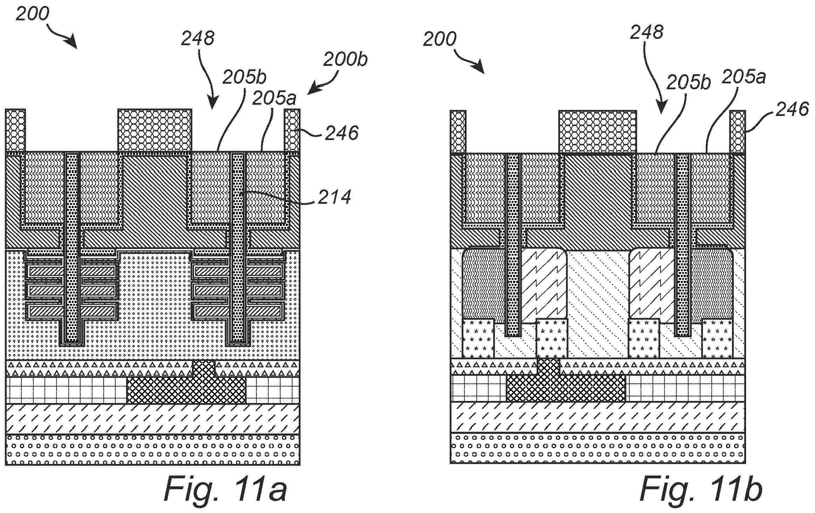

In Fig. 11a-b a mask layer 246 has been formed on the backside 200b and patterned to define an opening 248 exposing the base portion 205. Suitable materials for the mask layer 246 include for instance standard hardmask materials (metal or dielectric). The opening 248 may be patterned using a conventional lithography and etching process. As shown, corresponding openings may be formed to expose base portions along further dielectric walls.

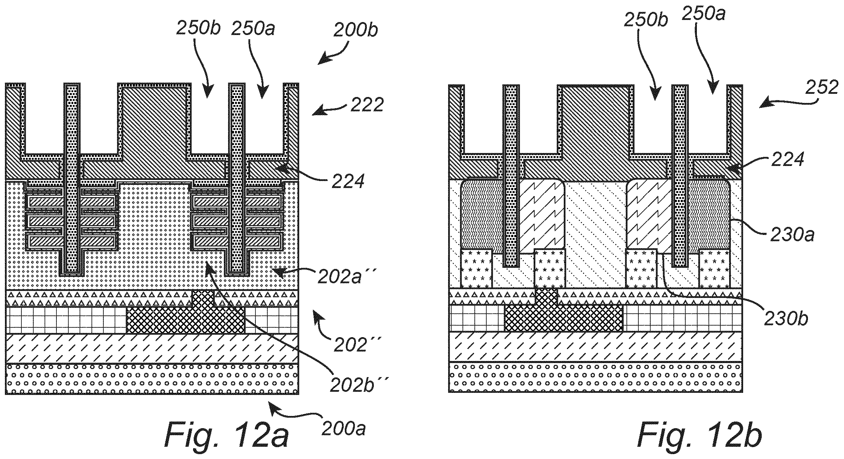

In Fig. 12a-b, the base portion 205 has been etched from the backside 200b, from the opening 248 in the mask layer 246 to form a first trench 250a underneath the first FET 202a" and a second trench 250b underneath the second FET 202b". The mask layer 246 has then been removed. The first and second trenches 250a, 250b are separated by the dielectric wall 214. The base portion 205 has more specifically been etched back from the backside 200b, in a direction towards the front side 200a, stopping on the bottom isolation layer 224 (e.g. a portion of the liner 218 in the illustrated example). The opening 248 in the mask layer 246 may be formed to expose the base portion 205 along at least a part of a length dimension of the base portion 205 (i.e. along the X-direction), hence allowing forming the first and second trenches 250a, 250b with a corresponding length dimension along the base portion 205. The first and second trenches 250a, 250b may be formed to extend underneath each first FET and each second FET, respectively, of any number of forksheet devices formed along the base portion 205. In particular, the opening 248 may be formed to expose the base portion 205 along its full length dimension, wherein the first and second trenches 250a, 250b may be coextensive with a length dimension of the base portion 205. The first and second trenches 250a, 250b are etched self-aligned to the dielectric wall 214 and the STI structure 222. Any suitable etching process (wet or dry, anisotropic or isotropic) with a sufficient selectivity to the semiconductor material of the base portion 205 may be used. The etching of the first and second trenches 250a, 250b is hence relatively insensitive to overlay errors between the opening 248 in the mask layer 246 and the base portion 205. Indeed, owing to the self-aligned properties of the trench formation process, pairs of first and second trenches may be etched simultaneously in a plurality of base portions along different dielectric walls from a common opening in a mask layer.

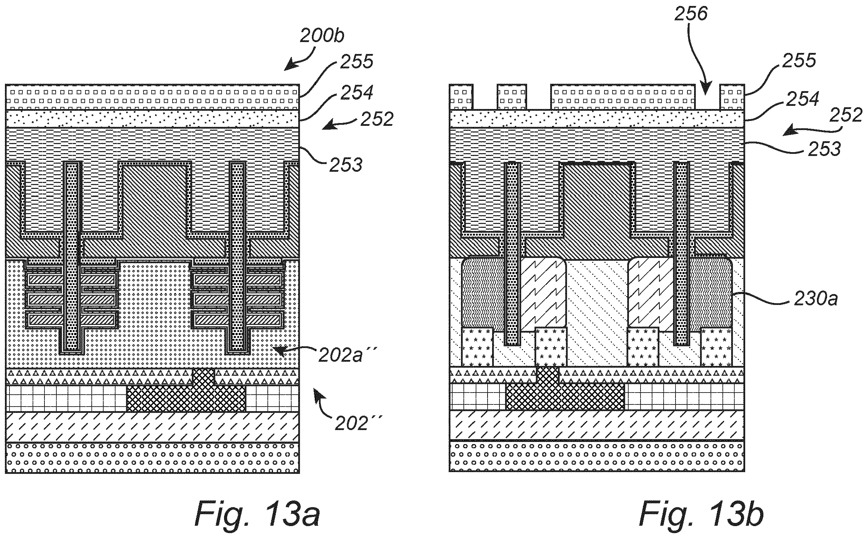

Fig. 13a-b to 15a-b show process steps for patterning a via opening in the bottom isolation layer 224 to expose the first source/drain region 230a of the first FET 202a".

In Fig. 13a-b a mask stack 252 has been formed on the backside 200b and patterned to define a mask opening 256 aligned with, i.e. overlying, the first source/drain region 230a. The mask stack 252 may be a conventional lithographic layer stack comprising for instance a mask fill layer 253 (e.g. an organic spin-on material such as spin-on-carbon), an anti-reflective coating 254 (e.g. a spin-on-glass) and a patterning film 255 (e.g. of a hardmask material). The opening 256 may be patterned in the patterning film 255 using a lithography and etching process.

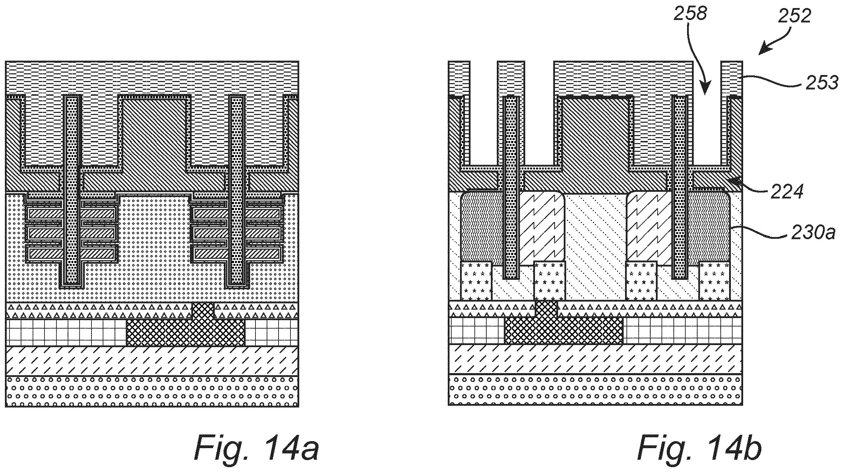

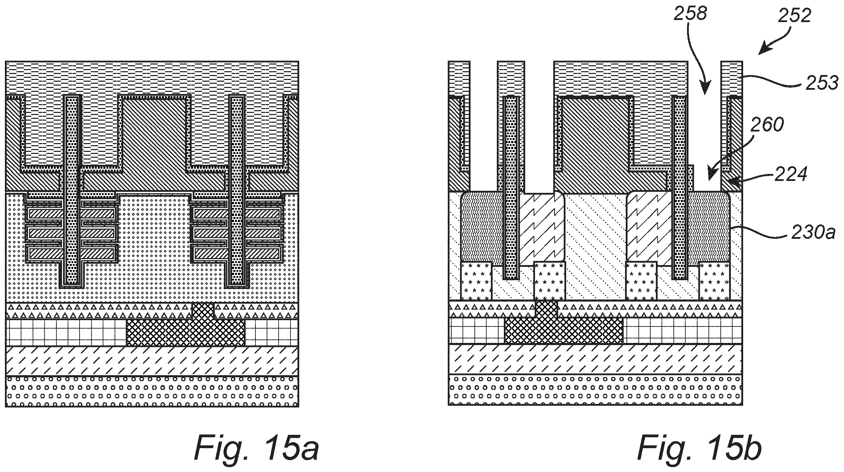

In Fig. 14a-b and 15a-b the opening 256 has been sequentially transferred into the lower layers of the mask stack 252, including the mask fill layer 253, to define a mask opening 258, and thereafter into the bottom isolation layer 224 to define a via opening 260 extending through the bottom isolation layer 224 (more specifically the first bottom isolation layer portion 224a) and exposing the first source/drain region 230a from the backside 200b. As shown in Fig. 14a-b, the mask stack 252 may be partially consumed during the via opening formation process.

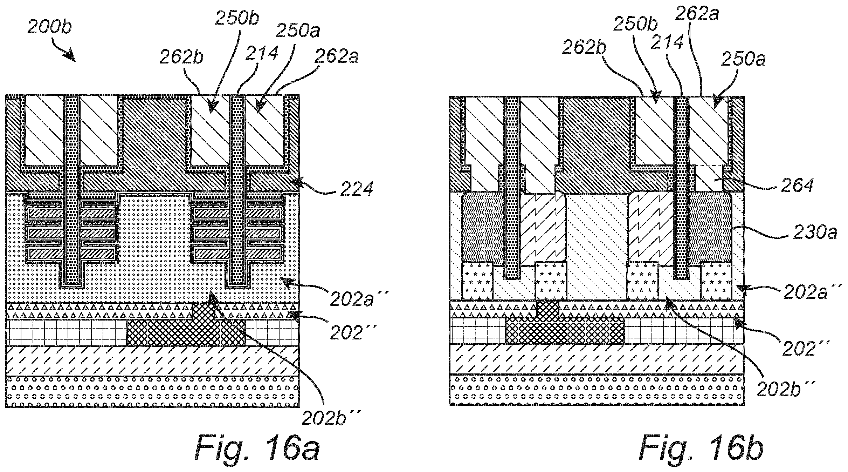

In Fig. 16a-b remaining portions of the mask stack 252 have been removed and the trenches 250a, 250b and the via opening 260 have been filled with conductive material to form a first BSWL 262a in the first trench 250a, a second BSWL 262b in the second trench 250b, and a conductive via 264 (e.g. forming an integral portion of the first BSWL 262a) in the via opening 260. The first BSWL 262a is hence connected to the first S/D region 230a of the first FET 202a" of the forksheet device 202" from the backside 200b, by the conductive via (portion) 264 in the via opening 260 in the bottom isolation layer 224. The first and second BSWLs 262a, 262b and the conductive via 264 may be formed by depositing one or more conductive materials, such as one or more metals (e.g. Ru, Mo, W optionally preceded with a metal barrier layer or liner), to fill the trenches 250a, 250b and the via opening 264. Overburden metal may subsequently be removed from the backside 200b by CMP and/or metal etch back. A corresponding via opening and conductive via may be formed to connect the second BSWL 262b to a respective S/D region of a second FET of any forksheet device formed along the dielectric wall 214. The first and second BSWLs 262a, 262b may accordingly be formed underneath each first FET and each second FET, respectively, formed along the dielectric wall 214.

After forming the first and second BSWLs 262a, 262b, the method may proceed with forming a backside interconnect structure 266 (corresponding to the backside interconnect structure 136 of the device 100) on the backside 200b of the device 200. The backside interconnect structure 266 may be formed employing conventional techniques used in the BEOL for forming frontside interconnect structures, such as damascene processing. The specific layout and details of the backside interconnect structure are beyond the scope of the present method and will hence not be further discussed herein.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming an integrated circuit device, comprising:
forming a forksheet device on a frontside of a substrate, the forksheet device comprising a first and a second transistor separated by a vertically oriented dielectric wall, wherein the forksheet device is formed over a base portion of the substrate and the dielectric wall extends into the base portion;
subsequent to forming the forksheet device, thinning the substrate from a backside of the substrate;
subsequent to the thinning, forming a first trench underneath the first transistor and a second trench underneath the second transistor by etching the base portion from the backside, the first and second trenches being separated by the dielectric wall; and
forming a first backside wiring line in the first trench and a second backside wiring line in the second trench.

2. A method according to claim 1, wherein the first and the second trenches are etched self-aligned to the dielectric wall.

3. A method according to claim 2, wherein the first and the second trenches are etched from a common opening patterned in a mask layer.

4. A method according to any one of the preceding claims, wherein the base portion is a fin-shaped semiconductor portion protruding from the substrate and wherein the method comprises thinning the substrate from the backside to expose the base portion from the backside.

5. A method according to claim 4, wherein forming the first and second trenches comprises etching the base portion to remove the base portion along at least a part of a length dimension thereof.

6. A method according to claim 5, wherein the base portion is surrounded by a shallow-trench isolation structure.

7. A method according to any one of claims 4-6, wherein the dielectric wall is coextensive with a length dimension of the base portion.

8. A method according to any one of the preceding claims, wherein the substrate comprises a first layer of a first semiconductor material and a second layer of a second semiconductor material on the first layer, wherein the second semiconductor material is different from each one of the first semiconductor material and a semiconductor material of the base portion, wherein the base portion is formed on the second layer, and wherein thinning the substrate comprises removing the first layer from the backside using the second layer as a stop layer, and subsequently opening the second layer to expose the base portion.

9. A method according to claim 8, wherein the dielectric wall extends through the base portion to the second layer.

10. A method according to any one of the preceding claims, wherein the first transistor and the second transistor are separated from the base portion by a bottom isolation layer, and wherein the method further comprises:
patterning a via opening in the bottom isolation layer, the via opening exposing a source/drain region of the first transistor; and
forming a conductive via in the via opening for connecting the first backside wiring line to the source/drain region.

11. A method according to any one of the preceding claims, wherein a plurality of forksheet devices are formed along a length dimension of the base portion, each forksheet device comprising a first transistor and a second transistor separated by the dielectric wall,
wherein the first trench and the first backside wiring line is formed underneath each first transistor and the second trench and the second backside wiring line is formed underneath each second transistor.

12. An integrated circuit device, comprising:
a forksheet device comprising a first transistor and second transistor separated by a vertically oriented dielectric wall; and
a first backside wiring line arranged underneath the first transistor and a second backside wiring line arranged underneath the second transistor, wherein the first backside wiring line and the second backside wiring line are separated by the dielectric wall.

13. An integrated circuit device according to claim 12, further comprising a bottom isolation layer separating the first backside wiring line from the first transistor and the second backside wiring line from the second transistor; and
a conductive via extending through the bottom isolation layer and connecting the first backside wiring line to a source/drain region of the first transistor.

14. An integrated circuit device according to any one of claims 12-13, further comprising a backside interconnect structure arranged underneath and connected to the first and the second backside wiring lines.

15. An integrated circuit device according to claim 14, wherein the first and second backside wiring lines are first and second backside power rails and wherein the backside interconnect structure forms a backside power delivery network.
